# EUROPÄISCHE PATENTSCHRIFT

(11) **EP 2 598 591 B1**
(45) Veröffentlichungstag und Bekanntmachung des Hinweises auf die Patenterteilung: **06.09.2017**
(21) Anmeldenummer: 11730919.5
(22) Anmeldetag: 08.07.2011
(51) Int. Cl.: C09J 7/00, A44B 18/00, B81B 1/00

(54) **HAFTVERSCHLUSSTEIL**
CONTACT CLOSURE COMPONENT
PIÈCE DE FERMETURE ADHÉSIVE

(30) Priorität: 30.07.2010 DE 102010032855
(43) Veröffentlichungstag der Anmeldung: 05.06.2013
(73) Patentinhaber: Gottlieb Binder GmbH & Co. KG, 71088 Holzgerlingen (DE)
(72) Erfinder: TUMA, Jan, 71083 Herrenberg (DE)
(74) Vertreter: Bartels, Martin Erich Arthur
(86) Internationale Anmeldenummer: PCT/EP2011/003426
(87) Internationale Veröffentlichungsnummer: WO 2012/013290

(56) Entgegenhaltungen:
- WO-A1-97/13981
- WO-A1-2008/102621
- DE-A1-102006 024 014
- DE-A1-102009 006 358

## Beschreibung

Die Erfindung betrifft ein Haftverschlussteil umfassend ein Trägerteil und darauf aufstehend angeordnete Verschlussteile, wobei jedes Verschlussteil zumindest ein eine vorgebbare Längenerstreckung aufweisendes Stielteil aufweist, wobei an zumindest einem Stielteil in zumindest einem Längenabschnitt zumindest ein Formgebungsabschnitt vorgesehen ist, der gegenüber einer fiktiven Stielteilaußenform zumindest teilweise in Richtung zum Stielinneren zurückgesetzt ist, wobei der zumindest eine Formgebungsabschnitt eine elastische Verform- und/oder Bewegbarkeit längs und/oder quer zur Längenerstreckung des jeweiligen Stielteils zumindest für dieses Stielteil ermöglicht und wobei mindestens ein Verschlussteil ein Kopfteil aufweist, wobei das jeweilige Kopfteil an seiner freien Stirnseite eine Kontaktfläche zur wieder lösbaren Anhaftung an ein Zweitbauteil mittels Adhäsionskraft aufweist.

Durch die WO 01/49776 A2 ist ein derartiges Haftverschlussteil bekannt, bei dem die freien Enden der Stielteile der einzelnen Verschlussteile mit einer Vielzahl von Einzelfasern versehen sind, wobei der Durchmesser der jeweiligen Faser sehr dünn zu wählen ist, so dass am freien Ende einer jeden Einzelfaser nur eine sehr kleine Kontaktfläche zur Verfügung steht in der Größenordnung von 0,2 bis 0,5 µm². Die genannte Größenordnung ermöglicht eine Wechselwirkung mit einem Zweitbauteil der Umgebung, an dem das Haftverschlussteil festgelegt werden soll, über die sogenannte Van-der-Waals-Wechselwirkung, die in klassischer Weise als Untergruppe der Adhäsion angesehen werden kann. Nach der Lehre der WO 01/49776 A2 werden Teile der Fußstruktur eines Geckos direkt als biologisches Material eingesetzt oder dieses künstlich nachempfunden, wobei die dahingehende Haftstruktur aus einer Vielzahl von sogenannten Spatulae-Komponenten besteht, die jeweils in der Art eines gebogenen konisch sich verbreiternden Verschlussteils sich am freien Ende in eine Vielzahl von Einzelfilamenten aufteilen.

Die WO 2008/102621 A1 beschreibt ein Klebeband mit einem Trägermaterial und ein Verschlussteil, wobei die Haftung des Klebebandes auf dem Haft-Prinzip eines Geckos basiert. Ein stielförmiger Teil des jeweiligen Verschlussteils weist mehrere Einkerbungen auf.

Die DE 10 2006 024 014 A1 beschreibt ein Haftverschlussteil mit einer Vielzahl von zueinander beabstandeten Haftelementen, die auf einem Trägerteil angeordnet sind, die jeweils ein Kopfteil aufweisen, das über ein Stielteil mit dem Trägerteil verbunden ist.

Die DE 10 2009 006 358 A1 beschreibt ein Haftverschlussteil mit einer Vielzahl von zueinander beabstandeten Verschlussteilen, die jeweils mittels eines Fußteils auf einem Trägerteil angeordnet sind und die jeweils ein Kopfteil aufweisen, das über ein Stielteil mit dem Fußteil verbunden ist, wobei das Kopfteil über ein Gelenkteil gelenkig mit dem Stielteil verbunden ist.

Die WO 97/13981 A1 beschreibt ein Befestigungsteil mit ersten und zweiten Befestigungselementen, wobei das erste Befestigungselement ein erstes Polymersubstrat mit von diesem vorstehenden ersten Eingreifelementen mit einer ersten Eingreiffläche aufweist, und wobei das zweite Befestigungselement mit einem zweiten Polymersubstrat mit mehreren von diesem vorstehenden zweiten Eingreifelementen, eine zweite Eingreiffläche aufweist, wobei ein Querschnitt durch die zweite Eingreiffläche der zweiten Eingreifelemente mehrere von dieser vorstehende zweite Mikrovorsprünge aufweist. Die ersten und zweiten Befestigungselemente sind zum Ineinandergreifen vorgesehen.

Die bekannten Haftverschlussteile weisen gute Verbindungseigenschaften auf, sind jedoch an ein entsprechend kostenintensives Herstellverfahren gebunden. Mit diesen bekannten Lösungen ist es möglich, die Ausbildung lösbarer Haftverbindungen für einen erweiterten Bereich von Materialien zur Verfügung zu stellen mit einer erhöhten Adhäsionsfähigkeit und der Möglichkeit, vorbestimmte Haltekräfte oder-eigenschaften einzustellen; es ist aufgrund der relativ starren Anordnung zwischen Kopfteil und Trägerteil über die gegebenenfalls geneigt angeordneten Stielteile noch Raum freigelassen für verbesserte Lösungen.

Ausgehend von diesem Stand der Technik stellt sich die Erfindung die Aufgabe, die Flexibilität des Haftverschlussteils im Hinblick auf unterschiedliche Haftanforderungen zu verbessern sowie die Adhäsionsfähigkeit zu erhöhen.

Diese Aufgabe wird erfindungsgemäß gelöst durch ein Haftverschlussteil mit den Merkmalen des Patentanspruches 1 in seiner Gesamtheit.

Dadurch, dass mehrere Formgebungsabschnitte als Einschnürung zumindest teilweise entlang des Umfangs des entsprechenden Stielteils verlaufend ausgebildet sind, wobei die Formgebungsabschnitte gegenüber einer fiktiven Stielteilaußenform zumindest teilweise in Richtung zum Stielinnern zurückgesetzt sind, ist eine elastische Verform- und/oder Bewegbarkeit längs und/oder quer zur Längenerstreckung des jeweiligen Stielteils ermöglicht und es kann sich das entsprechende Verschlussteil in verbesserter Weise, insbesondere unter Ausbildung einer größeren Wirk-Kontaktfläche, an ein Zweitbauteil anpassen und an dieses anhaften. Durch die Abnahme bzw. Aussparung von Material im Bereich des jeweiligen Formgebungsabschnitts entstehen Freiräume, in welche bzw. innerhalb welcher das jeweilige Stielteil bewegt werden kann, beispielsweise gedehnt oder gestaucht wird, in einer Rotations- und/oder Linearbewegung in axialer und/oder radialer Richtung bewegt wird.

Das jeweilige Kopfteil ist typischerweise pilzförmig ausgebildet. Bevorzugt ist der jeweilige Formgebungsabschnitt im Bereich des Kopfteils und/oder an das Kopfteil anschließend ausgebildet. Durch die Formgebungsabschnitte sind die Kopfteile in gewissem Maße von einer etwaigen Bewegung des jeweils zuordenbaren Stielteiles entkoppelt, so dass eine Art Dämpfung realisiert ist, die ein Verbleiben der Kontaktfläche am Zweitbauteil in erhöhtem Umfang gewährleistet, selbst wenn es bis zu einer vorgegebenen Grenzwertbelastung zu einer Relativbewegung zwischen Stielteil und zuordenbarem Kopfteil kommt.

Vorzugsweise erstreckt sich der Formgebungsabschnitt entlang des kompletten Umfangs des Stielteils. In eine radiale Richtung senkrecht zur Längenerstreckung des jeweiligen Stielteils verlaufende Formgebungsabschnitte haben den Vorteil, dass gleichförmige, anders ausgedrückt homogene, Verformungs- und/oder Bewegungseigenschaften des jeweiligen Stielteiles in sämtliche (radiale) Richtungen eingestellt werden können.

Weiter ist es vorteilhaft, dass die Einschnürung senkrecht zur Längenerstreckung des entsprechenden Stielteils regelmäßig verlaufend angeordnet und/oder ausgebildet ist. Neben einer einfachen Herstellungsweise ergibt sich hierbei der Vorteil richtungsunabhängig homogener Eigenschaften des jeweiligen Stielteils. Die Ausbildung und Anordnung der jeweiligen Formgebungsabschnitte wird entsprechend der gewünschten Eigenschaften des jeweiligen Stielteiles gewählt. Beispielsweise können eine oder mehrere Vorzugsrichtungen für die elastische Verformung bzw. Bewegung des jeweiligen Stielteils eingestellt werden, insbesondere an eine Abschälbewegung beim bestimmungsgemäßen Gebrauch des Haftverschlussteils angepasst werden.

Vorteilhafterweise weist die jeweilige Einschnürung in Richtung senkrecht zur Längenerstreckung des entsprechenden Stielteils die gleiche Tiefe auf und/oder legt die gleiche Breite des Stielteils fest. Die Stielteile sind typischerweise zylinderförmig ausgebildet, können jedoch auch Verjüngungs- und/oder Verbreiterungsbereiche aufweisen. Bilden mehrere Formgebungsabschnitte einen balgförmigen Längenabschnitt aus, so werden durch die gleiche Tiefe der entsprechenden Einschnürungen entlang des Längenabschnitts homogene Verformungs- bzw. Bewegungseigenschaften erreicht und somit eine Überlastung mit einhergehender Beschädigung einer bestimmten Stelle des Stielteils bei einer Verformung bzw. Bewegung weitestgehend vermieden.

In einer weiteren vorteilhaften Ausführungsform des erfindungsgemäßen Haftverschlussteils sind die Verschlussteile zumindest im Bereich der Stielteile und/oder des mindestens einen Formgebungsabschnitts jeweils rotationssymmetrisch ausgebildet. Die Rotationssymmetrie bezieht sich auf die Mittelachse des jeweiligen Stielteils, welche parallel zur Längenerstreckung des jeweiligen Stielteils verläuft. Rotationssymmetrisch ausgebildete Verschlussteile sind invariant gegenüber räumlich unterschiedlichen Anordnungen bzw. Ausrichtungen des Haftverschlussteils und können, da sie rotationsinvariante Verformungs- und/oder Bewegungseigenschaften aufweisen, in beliebiger radialer Ausrichtung auf dem Trägerteil angeordnet werden. Insoweit sind auch n-eckförmige Ausgestaltungen von Stiel- und/oder Kopfteil in diesem Sinne bei gleicher Ausgestaltung rotationssymmetrisch anzusehen.

Weiter ist es vorteilhaft, dass die Verschlussteile zumindest im Bereich des mindestens einen Formgebungsabschnitts und/oder des Stielteils gleichförmig ausgebildet sind. Zudem können die Verschlussteile in zumindest einem Flächenabschnitt des Trägerteils unter Ausbildung eines regelmäßigen Musters angeordnet sein. Hieraus ergibt sich der Vorteil homogener Eigenschaften eines mit den Verschlussteilen bestückten Trägerteils. Es ist zudem zweckmäßig, das Trägerteil einstückig mit den Verschlussteilen auszubilden. Zur Herstellung des erfindungsgemäßen Haftverschlussteils kann ein insbesondere mittels eines Mikro-Replikationsverfahrens verarbeitetes, besonders bevorzugt Polyvinylsiloxan enthaltendes Kunststoffmaterial verwendet werden.

Weiter kann sich das jeweilige Stielteil zwischen dem Kopfteil und einem Fußteil erstrecken, wobei das jeweilige Verschlussteil über das Fußteil mit dem Trägerteil verbunden ist. Besonders bevorzugt sind der bzw. die Formgebungsabschnitte im Bereich der gesamten Längenerstreckung des jeweiligen Stielteils angeordnet. Die Längenerstreckung des jeweiligen Stielteils beträgt typischerweise 100 µm und/oder die Breite des jeweiligen Stielteils typischerweise 30 bis 40 µm.

Bevorzugterweise stehen die Stielteile jeweils im Wesentlichen senkrecht auf dem Trägerteil auf und die durch die jeweiligen Kopfteile definierten Kontaktflächen verlaufen im Wesentlichen parallel zum Trägerteil. Insbesondere sind die Kontaktflächen bei gleichförmiger Ausbildung der Stielteile in einer gemeinsamen Ebene liegend angeordnet. Wichtig ist hierbei die gleiche Längenerstreckung der einzelnen Stielteile bzw. Verschlussteile einschließlich Kopfteile, gesehen von der ebenen Trägerteilfläche aus. Anstelle des sogenannten Zweitbauteils kann auch ein Drittbauteil treten.

Weitere Vorteile und Merkmale der Erfindung ergeben sich aus der Beschreibung und den Figuren der Zeichnung. Die in den Figuren gezeigten Merkmale sind rein schematisch und nicht maßstäblich zu verstehen. Es zeigt:
- Fig. 1: ein erfindungsgemäßes Haftverschlussteil mit mehreren Ver-schlussteilen in perspektivischer Darstellung;
- Fig. 2: ein Schnitt durch zwei in Fig. 1 gezeigte Verschlussteile;
- Fig. 3: eine Draufsicht auf ein in Fig. 1 und 2 gezeigtes Verschlussteil; und
- Fig. 4: eine Seitenansicht eines weiteren beispielhaften Verschlussteils.

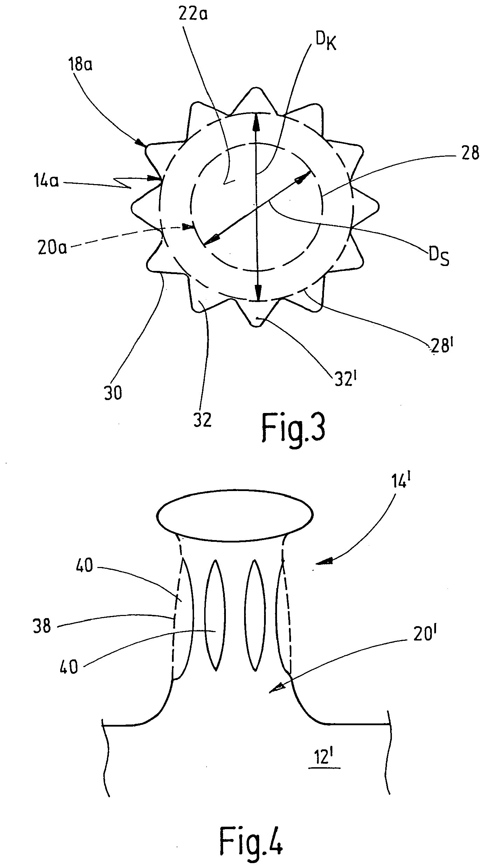

Die Ausführungsform der Fig. 3 und 4 dienen lediglich der Erläuterung des Hintergrundes der Erfindung. Diese Ausführungsformen sind nicht Gegenstand eines Anspruches.

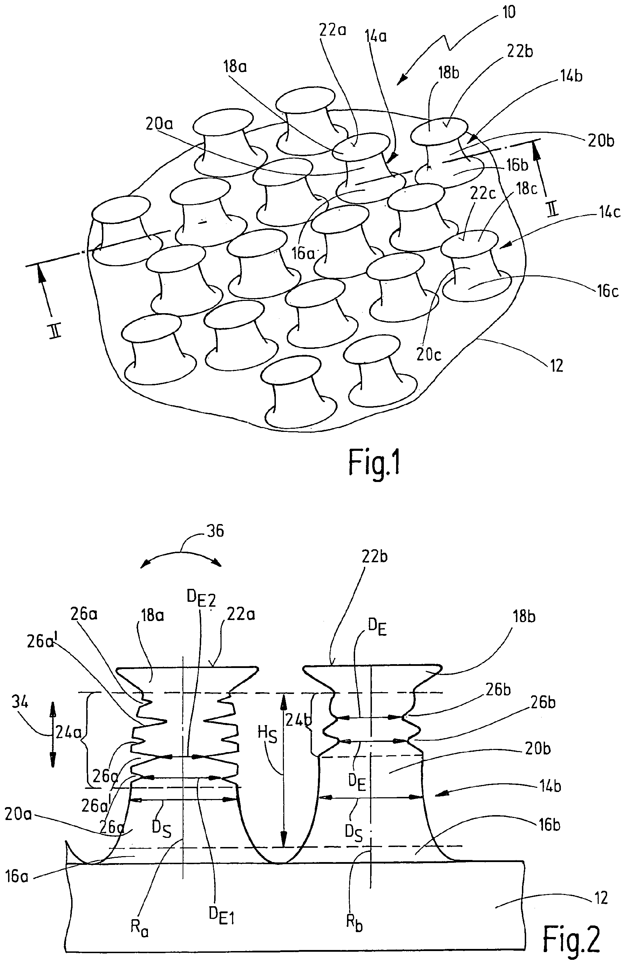

Fig. 1 zeigt ein Haftverschlussteil 10 mit einem flächigen Trägerteil 12 und darauf in regelmäßigen Abständen angeordneten Verschlussteilen 14a-14c, die jeweils ein Fußteil 16a-16c und ein Kopfteil 18a-18c aufweisen. Zwischen den Kopfteilen 18a-18c und den Fußteilen 16a-16c, über welche das jeweilige Verschlussteil 14a-14c mit dem Trägerteil 12 verbunden ist, erstreckt sich jeweils ein Stielteil 20a-20c. Am stirnseitigen Ende der Kopfteile 18a-18c ist jeweils eine kreisförmige flache Kontaktfläche 22a-22c ausgebildet, welche zur adhäsiven Anlage an ein (nicht gezeigtes) Zweitbauteil dient. Aufgrund der gleichförmigen Ausbildung der Verschlussteile 14a-14c liegen die Kontaktflächen 22a-22c in einer parallel zur Trägerfläche 12 verlaufenden Ebene.

Eine detailliertere Darstellung der Verschlussteile 14a und 14b findet sich in Fig. 2. Beide Verschlussteile 14a, 14b weisen in einem an das jeweilige Kopfteil 18a, 18b anschließenden Längenabschnitt 24a, 24b Einschnürungen 26a-26b auf. Beim links gezeigten Verschlussteil 14a sind die Einschnürungen 26a, 26a' entlang einer Längenerstreckung Hs des Stielteils 20a regelmäßig zueinander beabstandet, weisen jedoch unterschiedliche Einschnitttiefen in radialer Richtung senkrecht zur Längenerstreckung Hs auf. Die Einschnürungen 26a legen eine Dicke D_{E1} des Stielteils 20a fest, welche größer als die Dicke D_{E2} im Bereich der tieferen Einschnürungen 26a' ist.

Das weitere Stielteil 20a bzw. dessen Außenform ist durch den Stieldurchmesser Ds bestimmt. Die größte Breite weisen die beiden Verschlussteile 14a, 14b im Bereich des jeweiligen Fußteils 16a, 16b auf. Eine erste Bewegungsrichtung 34 und eine zweite Bewegungsrichtung 36 des Verschlussteils 14a sind mit entsprechenden Pfeilen angedeutet. Beide Verschlussteile 14a, 14b sind rotationssymmetrisch zur Mittelachse Rₐ, R_{b} des jeweiligen Stielteils 20a, 20b.

Beim in Fig. 2 rechts gezeigten Verschlussteil 14b sind zwei Einschnürungen 26b gezeigt, welche in axialer Richtung parallel zur Längenerstreckung Hs und in radialer Richtung senkrecht zur Längenerstreckung Hs gleichförmig angeordnet sind und jeweils vollumfänglich am Stielteil 20b ausgebildet sind und die Dicke D_{E} des Stielteils 20b festlegen. Aus Fig. 2 gut erkennbar ist die Anordnung der beiden Kontaktflächen 22a und 22b in einer gemeinsamen Ebene parallel zur Ebene des Trägerteils 12.

Fig. 3 zeigt in Draufsicht das Kopfteil 18a des entsprechenden Verschlussteils 14a, wobei das Stielteil 20a mit einer inneren Kreislinie 28 mit Durchmesser Ds angedeutet ist. Das das Stielteil 20a in radialer Richtung überragende Kopfteil 18a ist an der Kontaktfläche 22a im Wesentlichen kreisförmig entsprechend einer äußeren Kreislinie 28' mit Durchmesser D_{K} ausgebildet und weist randseitig eine wellige Außenkontur gebildet aus Zähnen 32, 32' auf. Durch die Zähne 32, 32' entstehen Abrisskanten, welche die Haftverschlusseigenschaften des Haftverschlussteils 10 mit dem Verschlussteil 14a verbessern.

Fig. 4 zeigt in Seitenansicht ein weiteres Verschlussteil 14, welches auf einem Träger 12' angeordnet ist, wobei in axialer Erstreckung entlang der Längenerstreckung des Stielteils 20' verlaufend angeordnete Einschnitte 40 vorgesehen sind, welche zum Inneren des Stielteils 20' zurückgesetzt gegenüber einer Außenform 38 sind. Durch die Einschnitte 40 ist das Verschlussteil 14' um die Mittelachse des Stielteils 20' bzw. des hier rotationssymmetrisch gezeigten Verschlussteils 14' dreh- bzw. bewegbar. Es versteht sich, dass weitere Ausgestaltungen von einem oder mehreren Formgebungsabschnitten an einzelnen Verschlussteilen denkbar sind. Insbesondere können unterschiedlich ausgestaltete Verschlussteile auf einem Trägerteil vorgesehen sein. Zweckmäßigerweise werden die Formgebungsabschnitte bei der Herstellung der Verschlussteile an diesen ausgebildet. Ein Trägerteil kann bedarfsoptimiert mit entsprechend ausgestalteten Verschlussteilen bestückt werden und demgemäß ein Haftverschlussteil ausgebildet werden.

Zum Herstellen des jeweiligen Haftverschlussteils können übliche Abformverfahren, wie beispielsweise Chill-Roll-Verfahren eingesetzt werden. Ferner können Mikro- oder Nanolithografieverfahren zur Anwendung kommen, einschließlich des sogenannten Mikro-Printing. Gegebenenfalls lässt sich die aufgezeigte Mikrostruktur auch mittels einer Art Kristallwachstum erreichen. Im Übrigen lässt sich das Verschlussmaterial auch aus dem Vollen generieren, beispielsweise unter Einsatz von Mikro-Funkenerosion oder entsprechender Laserstrahlbearbeitung.

## Patentansprüche

1. Haftverschlussteil (10) umfassend ein Trägerteil (12) und darauf aufstehend angeordnete Verschlussteile (14a-14c), wobei jedes Verschlussteil (14a-14c) zumindest ein eine vorgebbare Längenerstreckung (Hs) aufweisendes Stielteil (20a-20c) aufweist, wobei an zumindest einem Stielteil (20a-20c) in zumindest einem Längenabschnitt (24a, 24b) zumindest ein Formgebungsabschnitt (26a-26b) vorgesehen ist, der gegenüber einer fiktiven Stielteilaußenform (38) zumindest teilweise in Richtung zum Stielinneren zurückgesetzt ist, wobei der zumindest eine Formgebungsabschnitt (26a-26b) eine elastische Verform- und/oder Bewegbarkeit längs und/oder quer zur Längenerstreckung (Hs) des jeweiligen Stielteils (20a-20c) zumindest für dieses Stielteil ermöglicht und wobei mindestens ein Verschlussteil (14a-14c) ein Kopfteil (18a-18c) aufweist, wobei das jeweilige Kopfteil (18a-18c) an seiner freien Stirnseite eine Kontaktfläche (22a-22c) zur wieder lösbaren Anhaftung an ein Zweitbauteil mittels Adhäsionskraft aufweist, **dadurch gekennzeichnet, dass** mehrere Formgebungsabschnitte als Einschnürung (26a-26b) zumindest teilweise entlang des Umfangs des entsprechenden Stielteils (20a-20c) verlaufend ausgebildet sind.

2. Haftverschlussteil nach Anspruch 1, **dadurch gekennzeichnet, dass** die jeweilige Einschnürung (26a-26b)senkrecht zur Längenerstreckung (Hs) des entsprechenden Stielteils (20a-20c) regelmäßig verlaufend angeordnet und/oder ausgebildet ist.

3. Haftverschlussteil nach Anspruch 1 oder 2, **dadurch gekennzeichnet, dass** die jeweilige Einschnürung (26b) in einer Richtung senkrecht zur Längenerstreckung (Hs) des entsprechenden Stielteils (20b) die gleiche Tiefe aufweist und/oder die gleiche Breite (D_{E}) des Stielteils (20b) festlegt.

4. Haftverschlussteil nach einem der vorhergehenden Ansprüche, **dadurch gekennzeichnet, dass** mehrere Formgebungsabschnitte (26a-26b) einen balgförmigen Längenabschnitt (24a-24b) ausbilden.

5. Haftverschlussteil nach einem der vorhergehenden Ansprüche, **dadurch gekennzeichnet, dass** die Verschlussteile (14a-14c) zumindest im Bereich der Stielteile (20a-20c) und/oder der Formgebungsabschnitte (26a-26b) jeweils rotationssymmetrisch ausgebildet sind.

6. Haftverschlussteil nach einem der vorhergehenden Ansprüche, **dadurch gekennzeichnet, dass** die Verschlussteile (14a-14c) zumindest im Bereiche der Formgebungsabschnitte (26a-26b) und/oder der Stielteile (20a-20c) gleichförmig ausgebildet sind.

7. Haftverschlussteil nach einem der vorhergehenden Ansprüche, **dadurch gekennzeichnet, dass** der jeweilige Formgebungsabschnitt (26a-26b) - an das Kopfteil (18a-18c) anschließend ausgebildet ist.

8. Haftverschlussteil nach einem der vorhergehenden Ansprüche, **dadurch gekennzeichnet**, sich das jeweilige Stielteil (20a-20c) zwischen dem Kopfteil (18a-18c) und einem Fußteil (26a-26c) erstreckt, wobei das jeweilige Verschlussteil (14a-14c) über das Fußteil (16a-16c) mit dem Trägerteil (12) verbunden ist.

9. Haftverschlussteil nach einem der vorhergehenden Ansprüche, **dadurch gekennzeichnet, dass** der bzw. die Formgebungsabschnitte (26a-26b) im Bereich der gesamten Längenerstreckung (Hs) des jeweiligen Stielteils (20a-20c) angeordnet sind.

10. Haftverschlussteil nach einem der vorhergehenden Ansprüche, **dadurch gekennzeichnet, dass** das jeweilige Stielteil (20a-20c) eine Längenerstreckung (Hs) von etwa 100 µm und/oder eine Breite (Ds) von etwa 30 µm bis 40 µm aufweist.

## Claims

1. A touch-and-close fastener part (10) comprising a backing part (12) and fastener parts (14a-14c) which are arranged in an upright manner on said backing part, each fastener part (14a-14c) having at least one stem part (20a-20c) which has a pre-definable longitudinal extension (Hₛ), at least one shaping section (26a-26b) being provided on at least one stem part (20a-20c) in at least one longitudinal section (24a, 24b), which shaping section is set back at least partially with respect to a notional outer shape of the stem part (38) in the direction of the interior of the stem, the at least one shaping section (26a-26b) enabling elastic deformability and/or moveability along and/or transversely to the longitudinal extension (Hₛ) of the respective stem part (20a-20c), at least for this stem part, and at least one fastener part (14a-14c) having a head part (18a-18c), the respective head part (18a-18c) having on its free face side a contact surface (22a-22c) for re-detachable adhesion to a second component by means of adhesion force, **characterised in that** a number of shaping sections are formed as necking (26a-26b) that runs at least partially along the periphery of the corresponding stem part (20a-20c).

2. The touch-and-close fastener part according to Claim 1, **characterised in that** the respective necking (26a-26b) is arranged and/or configured so as to run regularly perpendicular to the longitudinal extension (Hs) of the corresponding stem part (20a-20c).

3. The touch-and-close fastener part according to Claim 1 or 2, **characterised in that** the respective necking (26b) exhibits the same depth and/or defines the same width (D_{E}) of the stem part (20b) in a direction perpendicular to the longitudinal extension (Hₛ) of the corresponding stem part (20b).

4. The touch-and-close fastener part according to any of the preceding claims, **characterised in that** a number of shaping sections (26a-26b) form a bellows-shaped longitudinal section (24a-24b).

5. The touch-and-close fastener part according to any of the preceding claims, **characterised in that** the fastener parts (14a-14c) are each made to be rotationally symmetrical, at least in the region of the stem parts (20a-20c) and/or of the shaping sections (26a-26b).

6. The touch-and-close fastener part according to any of the preceding claims, **characterised in that** the fastener parts (14a-14c) are made so as to have the same shape at least in the region of the shaping sections (26a-26b) and/or of the stem parts (20a-20c).

7. The touch-and-close fastener part according to any of the preceding claims, **characterised in that** the respective shaping section (26a-26b) is formed to be adjacent to the head part (18a-18c).

8. The touch-and-close fastener part according to any of the preceding claims, **characterised in that** the respective stem part (20a-20c) extends between the head part (18a-18c) and a base part (20a-20c), the respective fastener part (14a-14c) being connected to the backing part (12) by means of the base part (16a-16c).

9. The touch-and-close fastener part according to any of the preceding claims, **characterised in that** the shaping section or sections (26a-26b) is or are arranged in the region of the entire longitudinal extension (Hs) of the respective stem part (20a-20c).

10. The touch-and-close fastener part according to any of the preceding claims, **characterised in that** the respective stem part (20a-20c) has a longitudinal extension (Hₛ) of approximately 100 µm and/or a width (Dₛ) of approximately 30 µm to 40 µm.

## Revendications

1. Partie (10) de fermeture autoagrippante comprenant une partie (12) de support et des parties (14a à 14c) de fermeture qui s'y dressent, chaque partie (14a à 14c) de fermeture ayant au moins une partie (20a à 20c) de tige ayant une étendue (Hs) longitudinale pouvant être donnée à l'avance, dans laquelle il est prévu, sur au moins une partie (20a à 20c) de tige, dans au moins un tronçon (24a, 24b) longitudinal, au moins un tronçon (26a et 26b) donnant une forme, qui, par rapport à une forme (38) extérieure fictive de la partie de tige, est en retrait au moins dans une direction vers l'intérieur de la tige, dans laquelle le au moins un tronçon (26a et 26b) donnant une forme rend possible une possibilité de déformation et/ou de déplacement élastique longitudinalement et/ou transversalement à l'étendue (Hs) longitudinale de la partie (20a à 20c) de tige, au moins pour cette partie de tige, et dans laquelle au moins une partie (14a à 14c) de fermeture a une partie (18a à 18c) de tête, la partie (18a à 18c) de tête ayant sur son côté frontal libre une surface (22a à 22c) de contact pour l'agrippage pouvant se redéfaire sur une deuxième pièce au moyen d'une force d'agrippage, **caractérisée en ce que** plusieurs tronçons donnant la forme sont constitués sous la forme de strictions (26a et 26b) en s'étendant au moins en partie le long du pourtour de la partie (20a à 20c) de tige correspondante.

2. Partie de fermeture autoagrippante suivant la revendication 1, **caractérisée en ce que** la striction (26a et 26b) est disposée et/ou est constituée en s'étendant régulièrement perpendiculairement à l'étendue (Hs) longitudinale de la partie (20a à 20c) de tige correspondante.

3. Partie de fermeture autoagrippante suivant la revendication 1 ou 2, **caractérisée en ce que** la striction (26b) a, dans une direction perpendiculaire à l'étendue (Hs) longitudinale de la partie (20b) de tige correspondante, la même profondeur et/ou fixe la même largeur (D_{E}) de la partie (20b) de tige.

4. Partie de fermeture autoagrippante suivant l'une des revendications précédentes, **caractérisée en ce que** plusieurs tronçons (26a et 26b) donnant une forme constituent un tronçon (24a et 24b) longitudinal en forme de soufflet.

5. Partie de fermeture autoagrippante suivant l'une des revendications précédentes, **caractérisée en ce que** les parties (14a à 14c) de fermeture sont de révolution au moins dans la région des parties (20a à 20c) de tige et/ou des tronçons (26a et 26b) donnant une forme.

6. Partie de fermeture autoagrippante suivant l'une des revendications précédentes, **caractérisée en ce que** les parties (14a à 14c) de fermeture sont constituées uniformément au moins dans la région des tronçons (26a et 26b) donnant une forme et/ou des parties (20a à 20c) de tige.

7. Partie de fermeture autoagrippante suivant l'une des revendications précédentes, **caractérisée en ce que** le tronçon (26a et 26b) donnant une forme est constitué en se raccordant à la partie (18a à 18c) de tête.

8. Partie de fermeture autoagrippante suivant l'une des revendications précédentes, **caractérisée en ce que** la partie (20a à 20c) de tige s'étend entre la partie (18a à 18c) de tête et une partie (26a à 26c) de pied, la partie (14a à 14c) de fermeture étant reliée à la partie (12) de support par la partie (16a à 16c) de pied.

9. Partie de fermeture autoagrippante suivant l'une des revendications précédentes, **caractérisée en ce que** le ou les tronçons (26a et 26b) donnant une forme sont disposés dans la région de toute l'étendue (Hs) longitudinale de la partie (20a à 20c) de tige.

10. Partie de fermeture autoagrippante suivant l'une des revendications précédentes, **caractérisée en ce que** la partie (20a à 20c) de tige a une étendue (Hs) longitudinale d'environ 100 µm et/ou une largeur (Ds) d'environ 30 µm à 40 µm.
